Europäisches Patentamt

European Patent Office

Office européen des brevets

(11) Publication number: **0 280 198 B1**

## EUROPEAN PATENT SPECIFICATION

(45) Date of publication of patent specification: **02.09.92**

(51) Int. Cl.5: **C30B 23/02**, C30B 29/04, C23C 14/06

(21) Application number: **88102388.1**

(22) Date of filing: **18.02.88**

(54) **Method of forming diamond film.**

(30) Priority: **19.02.87 JP 37576/87**
**19.02.87 JP 37578/87**
**19.02.87 JP 37579/87**

(43) Date of publication of application:
**31.08.88 Bulletin 88/35**

(45) Publication of the grant of the patent:
**02.09.92 Bulletin 92/36**

(84) Designated Contracting States:
**DE FR GB**

(56) References cited:
**US-A- 4 490 229**

**PATENT ABSTRACTS OF JAPAN, vol. 10, no. 49 (C-330)[2106], 26th February 1986; & JP-A-60 195 094 (KOGYO GIJUTSUIN) 03-10-1985**

**THIN SOLID FILMS, vol. 96, no. 1, October 1982, pages 31-44, Elsevier Sequoia, Lausanne, CH; C. WEISSMANTEL et al.: "Preparation and properties of hard i-C and i-BN coatings"**

(73) Proprietor: **NISSIN ELECTRIC COMPANY, LIMITED**
**No.47, Umezu Takase-cho**
**Ukyo-ku Kyoto-shi Kyoto(JP)**

(72) Inventor: **Andoh, Yasunori c/o Nissin Electric Co., Ltd.**
**No. 47, Umezu Takase-cho Ukyo-ku**
**Kyoto-shi Kyoto(JP)**
Inventor: **Ogata, Kiyoshi c/o Nissin Electric Co., Ltd.**
**No. 47, Umezu Takase-cho Ukyo-ku**
**Kyoto-shi Kyoto(JP)**

(74) Representative: **Patentanwälte Grünecker, Kinkeldey, Stockmair & Partner**
**Maximilianstrasse 58**
**W-8000 München 22(DE)**

## Description

The present invention relates to a method of forming a diamond film on a substrate through vacuum evaporation and ion beam irradiation.

Conventionally, a chemical vapor-phase epitaxy method, such as a plasma CVD method, a photo CVD method, or the like, using a gas of hydrocarbon series or an organic compound has been employed as means for forming or synthesizing a diamond film on a substrate.

In the conventional methods, however, there have been the following problems:

(1) Simultaneously with the crystal growth of diamond, a deposition of graphite is generated in the case where a gas of hydrocarbon series or an organic compound is used

(2) It is necessary to treat the substrate and a gas atmosphere at a high temperature (for example, about $800°C \sim 1,000°C$), so that the material which can be used as the substrate is extremely limited.

It is therefore an object of the present invention to provide a method for forming a diamond thin film in which the above problems in the conventional art are solved.

Said object is achieved by claims 1 and 2.

In the method according to the present invention, evaporation of carbon and ion beam irradiation are performed on a substrate in a vacuum so as to form a diamond thin film on the substrate.

According to the present invention, when cabon evaporation and ion beam irradiation are performed on a substrate, the irradiation ions act as a nucleus formation energy supply source for causing carbon of the graphite structure deposited on the substrate to grow into crystals of diamond, thereby forming a diamond thin film on the substrate.

Other features and advantages of the present invention will be apparent from the following description taken in connection with the accompanying drawings.

Fig. 1 is a view showing a first embodiment of the apparatus for carrying out the method according to the present invention;

Fig. 2 is a view showing a second embodiment of the apparatus for carrying out the method according to the present invention; and

Fig. 3 is an enlarged schematic cross-section showing a part of an example of a substrate on which a diamond thin film is formed by means of the apparatus illustrated in Fig. 1 or 2.

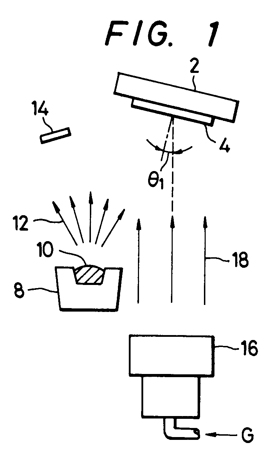

Fig. 1 is a schematic view showing a first embodiment of the apparatus for carrying out the method according to the present invention. A substrate (for example, a base plate) 4 attached to, for example, a holder 2 is housed in a vacuum vessel (not shown), and an evaporation source 8 and an ion source 16 are provided in opposition to the substrate 4.

The evaporation source 8 shown in Fig. 1 is an electron beam evaporation source which has a carbon pellet as an evaporation material 10 so that carbon 12 obtained by heat-evaporation of the carbon pellet 10 by means of an electron beam can be deposited on the surface of the substrate 4. However, since carbon has sublimating properties, the film forming velocity by means of such an electron beam evaporation source may be too slow for forming a diamond film. In that case, an evaporation source of the type in which a target including carbon is sputtered by an inert gas ion irradiation or by magnetron discharge, an evaporation source of the type in which carbon is evaporated by vacuum arc discharge at a cathode made of carbon, or the like, or any combination of the foregoing evaporation sources may be used as the evaporation source 8.

Being not limited to a specific one, preferably, the ion source 16 may be, for example, an ion source of the bucket type using a cusped magnet field for plasma confinement. In the bucked type ion source, a uniformly-ionized ion beam 18 having large sectional area can be irradiated onto the surface of the substrate 4, so that a large area of the substrate 4 can be treated at a time. A monitor 14 is provided to observe the thickness of a thin film to be formed on the substrate 4.

The ion beam 18 is a beam of a mixed gas of an inert gas selected from He, Ne, Ar, Kr, Xe, and Rn, and a gas of silicon series. The mixed gas is used as the gas G to be fed to the ion source 16.

The gas of silicon series can be a monosilane gas or a disilane gas. The concentration of the above-described gas of the silicon series is controlled by mixing or diluting it with the inert gas (such as an argon gas or a helium gas).

Since a gas of silicon series is used, the silicon irradiated in the form of the ion beam 18 takes only an $SP^3$ hybrid orbit so as to suppress the deposition of graphite and to act effectively on the formation of diamond.

In the following details of forming a diamond film according to the present invention are described. After the inside of the vacuum vessel has been exhausted, for example, to about $133 \times 10^{-5}$ to $133 \times 10^{-7}$ Pa ($10^{-5}$ to $10^{-7}$ Torr), the carbon 12 from the evaporation source 8 is deposited onto the substrate 4. Simultaneously or alternately with the deposition, the ion bean 18 from the ion source 16 is irradiating the substrate 4. In this case, it is preferable that the ratio (composition ratio) of the number of particles of the irradiation ions to that of the deposited carbon 12, that is ion/carbon, is selected within a range of from about 0.1% to 100%, and, specifically, is selected to be a suitable value in the above range in accordance with the energy of the ion beam 18 and the velocity of evaporation of the carbon 12. The ratio of the number of particles of the silicon ions irradiated in the form of the ion beam 18 to that of the carbon 12 deposited on the substrate 4 is sufficient if it is selected within a range of from about 0.1% to about 10%.

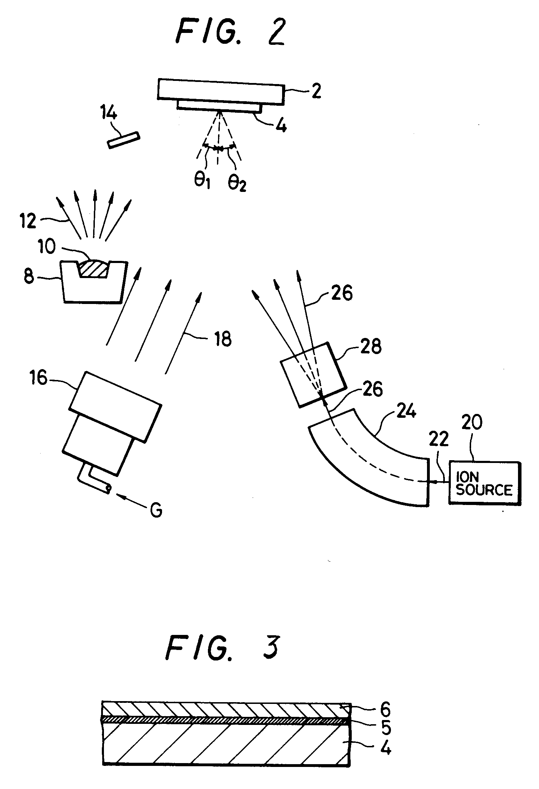

As a result of the above treatment, the ion irradiation acts as a nucleus forming energy supply source for making the carbon 12 having the graphite structure and deposited on the substrate 4 grow into diamond crystals to thereby form a diamond thin film 6 on the surface of the substrate 4, as shown in Fig. 3.

In view of the fact that the generation of damage (a defect portion) inside the diamond thin film 6 by the irradiation of the ion beam 18 has to be reduced to the utmost, it is preferable to select the energy of the ion beam 18 a low value not higher than about 10 KeV, more preferably not higher than about several hundreds electron volts. While there is no particular lower limit, the energy should not be lower than about 10 eV in practical use because there is a limit in drawing the ion beam 18 out of the ion source 16.

Preferably, the irradiation angle $\theta_1$ (that is, the angle between the direction of the ion beam 18 and a normal onto the surface of the substrate 4 as shown in Fig. 1) is selected to be within a range of from 0° to about 60°, so that sputtering of the deposited carbon 12 due to the irradiation of the ion beam 18 can be suppressed to a small amount.

Furthermore, in forming a film, as occasion demands, the substrate 4 may be heated by heating means (not shown) to about several hundreds degree (°C) or may be cooled by cooling means (not shown). If the substrate 4 is heated, not only the reaction for diamond formation can be hastened by thermal excitation but also defect portions caused in the diamond thin film 6 can be removed in the process of forming the film. If cooled, the substrate 4 can be protected when the substrate 4 is weak against heat.

The features of the film forming method as described above are listed as follows.

(1) The deposition of graphite can be suppressed by the energy of the irradiation ions, so that a uniform diamond thin film 6 can be obtained.

(2) As shown in the first embodiment, where an inert gas ion beam is used as the ion beam 18, a high-quality diamond thin film containing no impurity therein can be obtained. Particularly, if ions of He, Ne, or the like, which are light in weight, are irradiated, the above effect is made more remarkable because those ions may easily go out in the form of a gas from the film.

(3) Since thermal excitation is not used, low temperature treatment can be attained, so that the range of selection of the materials which can be used as the substrate 4 becomes extremely wide.

(4) The conventional methods have had problems that the kinetic energy of ions produced in a vapor phase is so small that the adhesion of the diamond thin film onto the substrate is poor and the diamond thin film is easily peeled off from the substrate. In the method according to the present invention, however, in the case where the energy of the ion beam 18 is made large to a certain extent within the range described already, a mixed layer 5 including materials of the substrate 4 and the diamond thin film 6 is formed through knock-on action of the ions in the vicinity of the interface between the substrate 4 and the diamond thin film 6, for example, as shown in Fig. 3, and the mixed layer 5 operates like a wedge, so that the adhesion of the diamond thin film 6 onto the substrate 4 is good, to thereby make the diamond thin film 6 be hardly peel off from the substrate 4.

(5) Since evaporation of the carbon 12 is used together with the ion beam irradiation, a diamond thin film 6 having larger thickness can be obtained in a short time in comparison with the conventional method, and therefore, good efficiency in forming the diamond thin film 6 is obtained in the present invention.

Fig. 2 is a schematic view showing a second embodiment of the apparatus for carrying out the method according to the present invention. That is, a gas ion beam 18 and a carbon ion beam 26 are irradiated onto carbon 12 deposited on a substrate 4. The gas ion beam 18 is an ion beam of a gas of silicon series, or an ion beam of a mixed gas of an inert gas and a gas of silicon series.

The ion source 20 is arranged as follows:

An ion beam 22 including carbon ions is drawn out from the ion source 20 with predetermined energy. The ion beam 22 is subjected to mass spectrometry by means of the mass spectrograph 24 or the like so as to extract a carbon ion beam 26. As occasion demands, the carbon ion beam 26 is scanned by the scanning electrode 28. As a result, the carbon ion beam 26 is enlarged in its sectional area, and the enlarged beam 26 is irradiated onto the surface of the substrate 4.

In the method of the second embodiment, the irradiation carbon ions 26 act not only as a nucleus forming energy supply source but also as a film forming carbon supply source, so that there is a further feature that the velocity of formation of the diamond thin film 6 is further improved in addition to the features (1) to (5) listed already.

As described above, according to the present invention, not only the deposition of graphite can be suppressed but also a high-quality diamond thin film containing no impurity therein can be efficiently formed. Furthermore, since a low temperature treatment can be attained, the range of selection of the materials which can be used as the substrate is widened. Furthermore, the adhesion of the diamond thin film onto the substrate can be improved.

## Claims

1. A method of forming a diamond film on a substrate comprising the steps of
placing a substrate in a vacuum housing;
evaporating carbon to be deposited on the substrate; and
irradiating the substrate with an ion beam
**characterized in that** an ion beam of a mixed gas of an inert gas selected from He, Ne, Ar, Kr, Xe and Rn, and a gas of silicon series is used.

2. A method of forming a diamond film on a substrate comprising the steps of
placing a substrate in a vacuum housing;
evaporating carbon to be deposited on the substrate; and
irradiating the substrate with an ion beam
**characterized in that** an ion beam of carbon and an ion beam of a gas of silicon series optionally mixed with an inert gas are used.

## Patentansprüche

1. Verfahren zur Bildung eines Diamantfilms bzw. einer Diamantschicht auf einem Substrat, das die folgenden Stufen umfaßt:
Geben eines Substrats in ein Vakuumgehäuse;
verdampfen von Kohlenstoff zum Abscheiden auf dem Substrat und
Bestrahlen des Substrats mit einem Ionenstrahl,
dadurch gekennzeichnet, daß ein Ionenstrahl aus einem gemischten Gas eines inerten Gases, gewählt aus He, Ne, Ar, Kr, Xe und Rn, und eines Gases der Siliciumreihe verwendet wird.

2. Verfahren zur Bildung eines Diamantfilms bzw. einer Diamantschicht auf einem Substrat, das die folgenden Stufen umfaßt:
Geben eines Substrats in ein Vakuumgehäuse;
Verdampfen von Kohlenstoff zum Abscheiden auf dem Substrat und
Bestrahlen des Substrats mit einem Ionenstrahl,

dadurch gekennzeichnet, daß ein Ionenstrahl aus Kohlenstoff und ein Ionenstrahl aus einem Gas der Siliciumreihe, ggf. gemischt mit einem inerten Gas, verwendet werden.

## Revendications

1. Procédé de formation d'une couche de diamant sur un substrat, comprenant les étapes suivantes :
disposition d'un substrat dans un récipient sous vide ;
évaporation de carbone destiné à être déposé sur le substrat ; et
irradiation du substrat avec un faisceau d'ions,
caractérisé en ce que l'on utilise un faisceau d'ions d'un mélange gazeux d'un gaz inerte choisi parmi He, Ne, Ar, Kr, Xe et Rn et d'un gaz de la série du silicium.

2. Procédé de formation d'une couche de diamant sur un substrat, comprenant les étapes suivantes :
disposition d'un substrat dans un récipient sous vide ;
évaporation de carbone destiné à être déposé sur le substrat ; et
irradiation du substrat avec un faisceau d'ions,
caractérisé en ce que l'on utilise un faisceau d'ions de carbone et un faisceau d'ions d'un gaz de la série du silicium éventuellement mélangé avec un gaz inerte.

# FIG. 1

## FIG. 2

## FIG. 3